# FASCICULE DE BREVET EUROPEEN

(11) **EP 4 199 531 B1**
(45) Date de publication et mention de la délivrance du brevet: **20.03.2024**
(21) Numéro de dépôt: 22213837.2
(22) Date de dépôt: 15.12.2022
(51) Int. Cl.: H04Q 9/00, H04B 3/54, G01R 22/06

(54) **SÉLECTION DE LA PHASE UTILISÉE POUR COMMUNIQUER PAR CPL**
PHASENAUSWAHL ZUR CPL-KOMMUNIKATION
PHASE SELECTION FOR PLC COMMUNICATION

(30) Priorité: 20.12.2021 FR 2113979
(43) Date de publication de la demande: 21.06.2023
(73) Titulaire: Sagemcom Energy & Telecom SAS, 92270 Bois-Colombes (FR)
(72) Inventeur: GRINCOURT, Christophe, 92500 Rueil Malmaison (FR); JEANROT, Marc, 92500 Rueil Malmaison (FR); POLVERARI, Flavien, 92500 Rueil Malmaison (FR)
(74) Mandataire: Cabinet Boettcher

(56) Documents cités:
- EP-A1- 2 811 262
- EP-A1- 2 887 557

## Description

L'invention concerne le domaine des compteurs électriques.

### ARRIERE PLAN DE L'INVENTION

Les compteurs électriques modernes sont des compteurs électroniques dits « intelligents » qui sont bien sûr conçus pour mesurer une énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Pour communiquer avec l'extérieur, et par exemple avec un autre compteur, avec un concentrateur de données, ou bien avec un serveur du Système d'Information (SI) du distributeur d'énergie (éventuellement via un autre compteur ou un concentrateur de données), les compteurs sont classiquement munis d'un module de communication mettant en oeuvre une communication par courants porteurs en ligne (CPL).

Généralement, tous les compteurs triphasés injectent les signaux CPL sur une même phase prédéterminée du réseau de distribution, qui est traditionnellement la phase 1. Par conséquent, dans un réseau de compteurs comprenant uniquement des compteurs triphasés, tous les compteurs injectent normalement les signaux CPL sur la même phase, et la qualité de la communication est normalement satisfaisante.

Cependant, les réseaux de compteurs comprennent à la fois des compteurs triphasés et des compteurs monophasés. Or, si le compteur le plus proche d'un compteur triphasé est un compteur monophasé, qui est connecté sur une phase autre que la phase 1, la qualité de la communication dépend alors du couplage capacitif entre les câbles, dont la qualité peut être très variable et très dépendante de l'environnement.

Le document EP 2 811 262 A1 décrit un procédé de décision de rattachement d'un premier compteur électrique à un second compteur électrique servant de relais audit premier compteur dans un réseau polyphasé d'alimentation.

### OBJET DE L'INVENTION

L'invention a pour objet d'améliorer la communication par courants porteurs en ligne dans un réseau de compteurs électriques comprenant à la fois des compteurs triphasés et des compteurs monophasés.

### RESUME DE L'INVENTION

En vue de la réalisation de ce but, on propose un compteur électrique, agencé pour mesurer une énergie électrique fournie à une installation par un réseau de distribution comprenant une pluralité de phases, le compteur électrique comportant :
- un module de communication agencé pour mettre en oeuvre une communication par courants porteurs en ligne ;
- un circuit de commutation agencé pour sélectivement connecter le module de communication à l'une des phases ;
- une unité de traitement agencée pour piloter le circuit de commutation de manière à connecter le module de communication à une phase optimisée, parmi les phases, qui est sélectionnée dynamiquement pour optimiser une qualité de la communication par courants porteurs en ligne.

L'unité de traitement du compteur selon l'invention pilote donc le circuit de commutation pour que celui-ci connecte le module de communication à la phase optimisée, qui est sélectionnée dynamiquement pour optimiser la qualité de la communication.

Ainsi, quels que soient les compteurs situés à proximité du compteur selon l'invention et avec lesquels communique le compteur selon l'invention, qu'il s'agisse de compteurs triphasés ou monophasés, la qualité de la communication est toujours satisfaisante.

On propose de plus un compteur électrique tel que précédemment décrit, dans lequel l'unité de traitement est agencée, pour chaque phase, pour évaluer la qualité de la communication par courants porteurs en ligne lorsque le module de communication est connecté à ladite phase, et pour sélectionner la phase optimisée en fonction d'un résultat de cette évaluation.

On propose de plus un compteur électrique tel que précédemment décrit, la qualité de la communication par courants porteurs en ligne étant évaluée en fonction d'au moins un paramètre de qualité comprenant un niveau de signal sur bruit et/ou un taux de réussite d'échanges de trames.

On propose de plus un compteur électrique tel que précédemment décrit, dans lequel, lorsqu'une technologie CPL G3 est utilisée pour mettre en oeuvre la communication par courants porteurs en ligne, le niveau de signal sur bruit est codé entre 0 et 255, et dans lequel, lorsqu'une technologie CPL PRIME est utilisée pour mettre en oeuvre la communication par courants porteurs en ligne, le niveau de signal sur bruit est évalué en dB.

On propose de plus un compteur électrique tel que précédemment décrit, dans lequel l'unité de traitement est agencée pour mettre en oeuvre les étapes de test et de connexion suivantes :
- piloter le circuit de commutation de sorte que celui-ci connecte successivement le module de communication à chaque phase ;
- pour chaque phase, lorsque le module de communication est connecté à ladite phase, évaluer ou acquérir le paramètre de qualité ;
- sélectionner comme phase optimisée la phase pour laquelle le paramètre de qualité est maximal, et piloter le circuit de commutation de sorte que celui-ci connecte le module de communication à ladite phase optimisée.

On propose de plus un compteur électrique tel que précédemment décrit, dans lequel l'unité de traitement est agencée pour mettre en oeuvre les étapes de test et de connexion à intervalles réguliers.

On propose de plus un compteur électrique tel que précédemment décrit, dans lequel l'unité de traitement est agencée pour :
- évaluer ou acquérir le paramètre de qualité lorsque le module de communication est connecté à une phase courante ;
- lorsque le paramètre de qualité devient inférieur à un seuil prédéfini, mettre en oeuvre les étapes de test et de connexion.

On propose de plus un compteur électrique tel que précédemment décrit, dans lequel l'unité de traitement est agencée pour recevoir une commande de sélection transmise par une entité externe, pour extraire de la commande de sélection un identifiant de la phase optimisée qui a été sélectionnée par l'entité externe, et pour piloter le circuit de commutation de manière à connecter le module de communication à ladite phase optimisée.

On propose de plus un compteur électrique tel que précédemment décrit, dans lequel le circuit de commutation comporte, pour chaque phase, un circuit unitaire comprenant :
- une entrée connectée au module de communication, et une sortie connectée à ladite phase ;
- un circuit interrupteur comprenant deux transistors et agencé pour, sélectivement, couper une liaison entre l'entrée et la sortie, ou bien permettre ladite liaison en laissant passer des alternances positives et négatives de signaux CPL émis par ou à destination du module de communication ;
- un circuit de commande agencé pour recevoir un signal de commande primaire produit par l'unité de traitement et pour produire un signal de commande secondaire pour piloter le circuit interrupteur.

On propose de plus un procédé de sélection, mis en oeuvre dans un compteur tel que précédemment décrit, et comprenant les étapes de test et de connexion suivantes :
- piloter le circuit de commutation de sorte que celui-ci connecte successivement le module de communication à chaque phase ;
- pour chaque phase, lorsque le module de communication est connecté à ladite phase, évaluer ou acquérir le paramètre de qualité ;
- sélectionner comme phase optimisée la phase pour laquelle le paramètre de qualité est maximal, et piloter le circuit de commutation de sorte que celui-ci connecte le module de communication à ladite phase optimisée.

On propose de plus un programme d'ordinateur comprenant des instructions qui conduisent l'unité de traitement du compteur électrique tel que précédemment décrit à exécuter les étapes du procédé de sélection tel que précédemment décrit.

On propose en outre un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

### BREVE DESCRIPTION DES DESSINS

Il sera fait référence aux dessins annexés parmi lesquels :
[Fig. 1] la figure 1 représente un compteur électrique selon l'invention ;
[Fig. 2] la figure 2 représente le circuit de commutation ;
[Fig. 3] la figure 3 représente des étapes d'un procédé de sélection selon un premier mode de réalisation ;
[Fig. 4] la figure 4 représente des étapes d'un procédé de sélection selon un deuxième mode de réalisation.

### DESCRIPTION DETAILLEE DE L'INVENTION

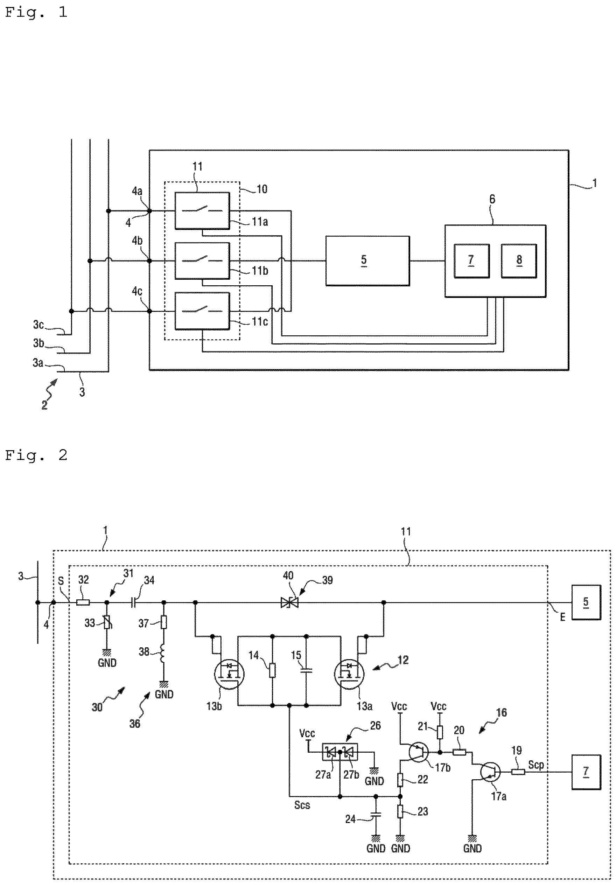

En référence à la figure 1, le compteur électrique 1 selon l'invention est un compteur triphasé qui est destiné à mesurer une énergie électrique fournie à l'installation électrique d'un abonné par un réseau de distribution 2.

Le réseau de distribution 2 comprend une pluralité, en l'occurrence trois phases 3 (et un neutre, non représenté) : une phase 3a, une phase 3b et une phase 3c. La phase 3a est la phase 1 évoquée plus tôt.

Le compteur 1 comprend trois ports d'entrée 4 connectés chacun à l'une des phases 3 du réseau de distribution : un port d'entrée 4a, un port d'entrée 4b et un port d'entrée 4c.

Le compteur 1 comporte aussi des capteurs de tension et des capteurs de courant (non représentés), qui mesurent, pour chaque phase 3, la tension de phase présente sur ladite phase 3 et le courant de phase circulant sur ladite phase 3.

Le compteur 1 comporte de plus un module de communication 5 agencé pour mettre en oeuvre une communication par courants porteurs en ligne (CPL). Le module de communication 5 est conçu pour injecter des signaux CPL sortants sur l'une des phases 3 (qui, comme on le verra, n'est pas la même systématiquement) et pour acquérir des signaux CPL entrants sur ladite phase 3.

Le compteur 1 comporte de plus une unité de traitement 6, qui est une unité électronique et logicielle, et qui comprend un ou plusieurs composants de traitement montés sur une ou plusieurs cartes électriques.

Le ou les composants de traitement comprennent par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Spécifie Integrated Circuit*). Les composants de traitement sont adaptés à exécuter des instructions de programmes. L'unité de traitement 6 comprend ici notamment le microcontrôleur applicatif 7 du compteur 1.

L'unité de traitement 6 comprend aussi une ou des mémoires 8. Au moins l'une des mémoires 8 forme un support d'enregistrement lisible par ordinateur, sur lequel est enregistré un programme d'ordinateur comprenant des instructions qui conduisent l'unité de traitement 6 à exécuter au moins certaines des étapes du procédé de sélection qui sera décrit plus bas.

Le compteur 1 comporte aussi un circuit de commutation 10 qui permet de sélectivement connecter le module de communication 5 à l'une des phases.

Le circuit de commutation 10 comprend, pour chaque phase 3, un circuit unitaire 11 ; il y a donc un circuit unitaire 11a, un circuit unitaire 11b et un circuit unitaire 11c.

En référence à la figure 2, chaque circuit unitaire 11 comprend une entrée E connectée à une entrée/sortie du module de communication 5, et une sortie S reliée à une (seule) phase 3 via le port d'entrée 4 associé.

Le circuit unitaire 11 comprend aussi un circuit interrupteur 12, agencé pour, sélectivement, couper une liaison entre l'entrée E et la sortie S du circuit unitaire 11, ou bien permettre ladite liaison en laissant passer des alternances positives et négatives des signaux CPL sortants ou entrants, émis par ou à destination du module de communication 5 (dont la fréquence est comprise entre 30Khz et 500Khz).

Le circuit interrupteur 12 comprend deux transistors MOSFET 13a, 13b (à canal N).

Le drain du premier transistor 13a est relié à l'entrée E du circuit unitaire 11. Les sources du premier transistor 13a et du deuxième transistor 13b sont reliées entre elles. Les grilles du premier transistor 13a et du deuxième transistor 13b sont reliées entre elles. Une résistance 14 et un condensateur 15 sont montés en parallèle et ont chacun une première borne reliée aux sources, et une deuxième borne reliée aux grilles des transistors 13a, 13b.

Le circuit unitaire 11 comprend de plus un circuit de commande 16 agencé pour recevoir un signal de commande primaire Scp produit par le microcontrôleur 7 et pour produire un signal de commande secondaire Scs pour piloter le circuit interrupteur 12.

Le signal de commande primaire Scp est, à l'état haut, un signal de tension 3,3V. Le signal de commande secondaire Scs est, à l'état haut, un signal de tension 15V. Le circuit de commande 16 réalise donc une adaptation du signal de commande primaire Scp pour commander le circuit interrupteur 12.

Le circuit de commande 16 comprend deux transistors bipolaires 17a, 17b : le transistor 17a est de type NPN et le transistor 17b est de type PNP.

La base du transistor 17a est connectée à une sortie du microcontrôleur 7 via une résistance 19. L'émetteur du transistor 17a est connecté à la masse GND. Le collecteur du transistor 17a est connecté à la base du transistor 17b via une résistance 20. La base du transistor 17b est reliée à une source d'alimentation VCC via une résistance 21. La source d'alimentation Vcc fournit une alimentation sous une tension continue de 15V. L'émetteur du transistor 17b est relié à la source d'alimentation Vcc. Le collecteur du transistor 17b est connecté à une première borne d'une résistance 22, dont une deuxième borne est connectée à une première borne d'une résistance 23. La deuxième borne de la résistance 23 est connectée à la masse.

La deuxième borne de la résistance 22 est aussi connectée à une première borne d'un condensateur 24, dont une deuxième borne est connectée à la masse. La deuxième borne de la résistance 22 est aussi connectée aux grilles des transistors 13a, 13b.

Le circuit unitaire 11 comprend aussi un circuit de protection 26 contre les surtensions du circuit de commande, qui protège de remontées de tension sur la source d'alimentation Vcc. Le circuit de protection 26 comprend deux diodes Schottky 27a, 27b. La cathode de la diode Schottky 27a est connectée à la source d'alimentation Vcc. La cathode de la diode Schottky 27b est connectée à l'anode de la diode Schottky 27a. L'anode de la diode Schottky 27b est connectée à la masse. L'anode de la diode Schottky 27a est connectée aux grilles des transistors 13a, 13b.

Le circuit unitaire 11 comprend aussi un circuit frontal 30, connecté à la sortie S du circuit unitaire 11 et donc à la phase 3.

Le circuit frontal 30 comprend un circuit de protection foudre 31 (par exemple à 2kV) comprenant une résistance 32 ayant une première borne reliée à la sortie S, et une varistance 33 ayant une première borne reliée à la masse et une deuxième borne reliée à une deuxième borne de la résistance 32.

Le circuit frontal 30 comprend aussi un condensateur de couplage 34, permettant d'injecter les signaux CPL sortants sur la phase 3. Le condensateur de couplage 34 bloque le 50Hz, c'est-à-dire la fréquence de la tension de phase et du courant de phase. Le condensateur de couplage 34 a une première borne reliée à la deuxième borne de la résistance 32.

Le circuit frontal 30 comprend de plus un « circuit bouchon » 36 qui permet de fermer le circuit d'entrée à 50Hz quand le circuit interrupteur 12 est ouvert, sans impacter les signaux haute fréquence (>10Khz - et donc les signaux CPL) quand le circuit interrupteur 12 est fermé.

Le circuit bouchon 36 comprend une résistance 37 et une inductance 38. La résistance 37 a une première borne connectée à une deuxième borne du condensateur de couplage 34 et au drain du transistor 13b. L'inductance 38 a une première borne connectée à la deuxième borne de la résistance 37 et une deuxième borne reliée à la masse.

Le circuit unitaire 11 comprend aussi un circuit de protection 39 contre les surtensions du circuit interrupteur 12 lorsque celui-ci est ouvert.

Le circuit de protection 39 comprend une diode Transil bidirectionnelle 40 ayant une première borne connectée à l'entrée E du circuit unitaire 11 et au drain du transistor 13a, et une deuxième borne connectée au drain du transistor 13b.

Le circuit de protection 39 permet de limiter la tension à 10V aux bornes des transistors 13a, 13b quand ils sont ouverts (bloqués).

Le circuit unitaire 11 permet de réaliser la connexion entre la phase 3 du réseau de distribution 2 et la sortie du module de communication 5, au travers des protections précédemment décrites. Le signal de commande primaire Scp, qui provient du microcontrôleur 7, permet de piloter les deux transistors 13a, 13b pour autoriser ou au contraire interdire le transit de signaux CPL.

Par conséquent, lorsque le microcontrôleur 7 produit sur sa sortie un signal de commande primaire Scp à l'état haut, le circuit unitaire 11 laisse passer les signaux CPL entre le module de communication 5 et la phase 3, qui est donc la phase sélectionnée pour mettre en oeuvre la communication CPL. Au contraire, lorsque le microcontrôleur 7 produit sur sa sortie un signal de commande primaire Scp à l'état bas, la communication CPL se fait sur une autre phase. Il n'y a qu'une phase sélectionnée à la fois.

La phase en question est sélectionnée pour optimiser la qualité de la communication CPL : on parlera de phase « optimisée ».

Dans le compteur 1, le microcontrôleur 7 peut en effet évaluer la qualité de la communication CPL lorsque le module de communication 5 est connecté à chacune des phases, et peut donc sélectionner dynamiquement la phase optimisée en fonction du résultat de cette évaluation. Par « dynamiquement », on entend que cette sélection peut évoluer au fil du temps en fonction de l'évolution de la qualité de la communication CPL.

Le microcontrôleur 7 évalue la qualité de la communication CPL en fonction d'au moins un paramètre de qualité. Le microcontrôleur 7 peut évaluer (via des mesures, des calculs, etc.) la valeur du paramètre de qualité, ou bien acquérir ladite valeur.

Le paramètre de qualité est par exemple un niveau de signal sur bruit.

Lorsque la technologie CPL G3 est utilisée pour mettre en oeuvre la communication CPL, le niveau de signal sur bruit est codé entre 0 et 255 ; on parle alors de LQI, pour *Link Quality Indicator.*

Lorsque la technologie CPL PRIME est utilisée pour mettre en oeuvre la communication CPL, le niveau de signal sur bruit est évalué en dB ; on parle alors de SNR, pour *Signal to Noise Ratio.*

Le paramètre de qualité est par exemple un taux de réussite d'échanges de trames.

En effet, lorsqu'il est connecté à un concentrateur de données, le compteur 1 reçoit classiquement une information représentative du nombre de trames correctement transmises par le compteur 1 audit concentrateur de données sur une durée prédéfinie (24h typiquement), ce qui permet au compteur 1 de connaître le taux de réussite d'échanges de trames, qui est un bon indicateur de la qualité de la communication CPL.

Le compteur 1 est ainsi capable de sélectionner la phase optimisée qui lui permettra de communiquer en CPL avec la meilleure qualité possible.

Le compteur 1 pourra aussi s'adapter en changeant la phase à laquelle est couplé le module de communication 5, en fonction notamment de la topologie du réseau, suite par exemple à l'ajout de nouveaux compteurs sur la grappe.

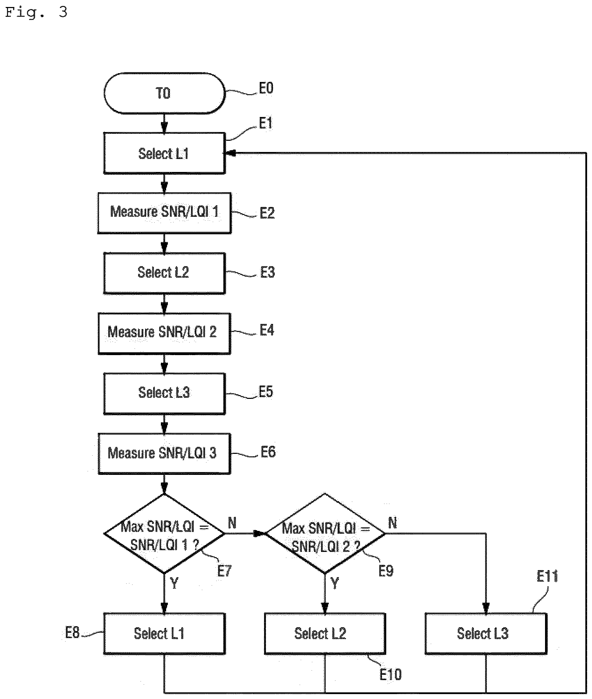

On décrit maintenant, en référence à la figure 3, un procédé de sélection de la phase optimisée, selon un premier mode de réalisation.

Le procédé de sélection comprend des étapes de test et de connexion.

Dans le premier mode de réalisation du procédé de sélection, les étapes de test et de connexion sont réalisées à intervalles réguliers, quotidiennement par exemple, et consistent à effectuer un scan des trois phases 3 afin de choisir celle qui est associée au meilleur paramètre de qualité, puis à connecter le module de communication 5 sur la phase choisie.

Au cours des étapes de test et de connexion, le microcontrôleur 7 pilote le circuit de commutation 10 de sorte que celui-ci connecte successivement le module de communication 5 à chaque phase 3. Puis, pour chaque phase 3, lorsque le module de communication 5 est connecté à ladite phase 3, le microcontrôleur 7 évalue ou acquiert le paramètre de qualité. Le microcontrôleur 7 sélectionne alors comme phase optimisée la phase pour laquelle le paramètre de qualité est maximal, et pilote le circuit de commutation 10 de sorte que celui-ci connecte le module de communication 5 à ladite phase optimisée.

On considère par exemple que le paramètre de qualité utilisé est le SNR.

Le procédé de sélection démarre au temps T0 (étape E0).

Le microcontrôleur 7 sélectionne la phase 3a (étape E1), c'est-à-dire qu'il pilote le circuit de commutation 10 pour autoriser la transmission des signaux CPL entre l'entrée et la sortie du circuit unitaire 11a associé à la phase 3a, et qu'il bloque cette transmission pour les autres circuits unitaires 11b, 11c.

Le microcontrôleur 7 évalue ou acquiert alors le SNR (étape E2).

Puis, le microcontrôleur 7 sélectionne la phase 3b (étape E3), et évalue ou acquiert alors le SNR (étape E4).

Puis, le microcontrôleur 7 sélectionne la phase 3c (étape E5), et évalue ou acquiert alors le SNR (étape E6).

Le microcontrôleur 7 vérifie alors si la valeur maximale du SNR est la valeur de SNR obtenue pour la phase 3a (étape E7) .

Si c'est le cas, le microcontrôleur 7 sélectionne la phase 3a, qui est donc la phase optimisée à laquelle est connecté le module de communication 5 pour les 24h qui suivent (étape E8). Le microcontrôleur 7 attend alors une durée T1 = 24h, puis le procédé repasse à l'étape E1.

A l'étape E7, si la valeur maximale du SNR n'est pas la valeur de SNR obtenue pour la phase 3a, le microcontrôleur 7 vérifie si la valeur maximale du SNR est la valeur de SNR obtenue pour la phase 3b (étape E9).

Si c'est le cas, le microcontrôleur 7 sélectionne la phase 3b, qui est donc la phase optimisée à laquelle est connecté le module de communication 5 pour les 24h qui suivent (étape E10). Le microcontrôleur 7 attend alors une durée T1 = 24h, puis le procédé repasse à l'étape E1.

A l'étape E9, si la valeur maximale du SNR n'est pas la valeur de SNR obtenue pour la phase 3b, le microcontrôleur 7 sélectionne la phase 3c, qui est donc la phase optimisée à laquelle est connecté le module de communication 5 pour les 24h qui suivent (étape E11). Le microcontrôleur 7 attend alors une durée T1 = 24h, puis le procédé repasse à l'étape E1.

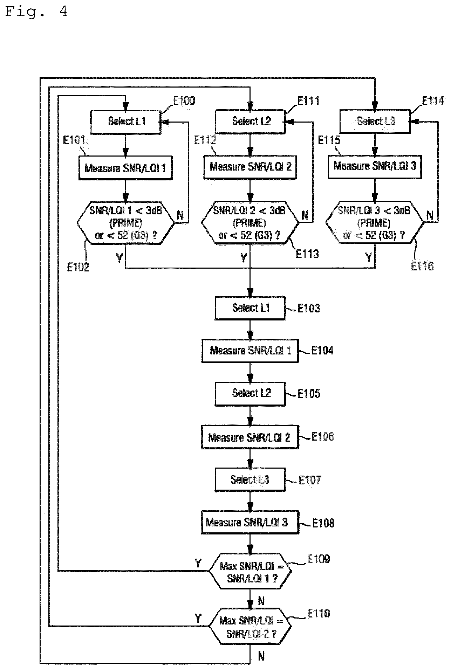

Dans un deuxième mode de réalisation, en référence à la figure 4, les étapes de test et de connexion ne sont réalisées que lorsque la qualité de communication n'est pas satisfaisante.

Le microcontrôleur 7 évalue ou acquiert le paramètre de qualité lorsque le module de communication 5 est connecté à une phase courante. Lorsque le paramètre de qualité devient inférieur à un seuil prédéfini, le microcontrôleur 7 met en oeuvre les étapes de test et de connexion pour sélectionner la phase optimisée (qui a priori sera une phase différente de la phase courante).

Ce procédé suppose de sélectionner par défaut une phase optimisée lors de l'installation du compteur 1 (ou lors de l'initialisation du programme permettant de mettre en oeuvre l'invention).

On considère donc que la phase courante est la phase 3a : la phase sélectionnée est la phase 3a (étape E100) .

Le microcontrôleur 7 évalue ou acquiert alors le SNR (étape E101).

Le microcontrôleur 7 compare le SNR avec un seuil prédéfini (par exemple égal à 3dB) : étape E102.

Si le SNR est supérieur ou égal au seuil prédéfini, le procédé repasse à l'étape E100.

Si le SNR est inférieur au seuil prédéfini, le microcontrôleur 7 démarre les étapes de test et de connexion.

Le microcontrôleur 7 sélectionne tout d'abord la phase 3a (étape E1003), et évalue ou acquiert alors le SNR (étape E104).

Puis, le microcontrôleur 7 sélectionne la phase 3b (étape E105), et évalue ou acquiert alors le SNR (étape E106) .

Puis, le microcontrôleur 7 sélectionne la phase 3c (étape E107), et évalue ou acquiert alors le SNR (étape E108) .

Le microcontrôleur 7 vérifie alors si la valeur maximale du SNR est la valeur de SNR obtenue pour la phase 3a (étape E109) .

Si c'est le cas, le microcontrôleur 7 sélectionne la phase 3a, qui est la phase optimisée à laquelle est alors connecté le module de communication 5 (étape E100). Le microcontrôleur 7 attend alors une durée T2 = 5h, puis le procédé repasse à l'étape E101.

A l'étape E109, si la valeur maximale du SNR n'est pas la valeur de SNR obtenue pour la phase 3a, le microcontrôleur 7 vérifie alors si la valeur maximale du SNR est la valeur de SNR obtenue pour la phase 3b (étape E110) .

Si c'est le cas, le microcontrôleur 7 sélectionne la phase 3b, qui est la phase optimisée à laquelle est alors connecté le module de communication 5 (étape E111). Le microcontrôleur attend alors une durée T2 = 5h, puis le procédé passe à l'étape E112.

A l'étape E112, le microcontrôleur 7 évalue ou acquiert le SNR.

Le microcontrôleur 7 compare le SNR avec le seuil prédéfini (étape E113) .

Si le SNR est supérieur ou égal au seuil prédéfini, le procédé repasse à l'étape E111.

Si le SNR est inférieur au seuil prédéfini, le microcontrôleur 7 démarre les étapes de test et de connexion (E103 à E110) .

A l'étape E110, si la valeur maximale du SNR n'est pas la valeur de SNR obtenue pour la phase 3b, le microcontrôleur 7 sélectionne la phase 3c, qui est la phase optimisée à laquelle est alors connecté le module de communication 5 (étape E114). Le microcontrôleur 7 attend alors une durée T2 = 5h, puis le procédé passe à l'étape E115.

A l'étape E115, le microcontrôleur 7 évalue ou acquiert le SNR.

Le microcontrôleur 7 compare le SNR avec le seuil prédéfini (étape E116).

Si le SNR est supérieur ou égal au seuil prédéfini, le procédé repasse à l'étape E114.

Si le SNR est inférieur au seuil prédéfini, le microcontrôleur 7 démarre les étapes de test et de connexion (E103 à E110).

La durée prédéterminée T2 permet de maintenir la stabilité de la topologie du réseau. Il faut en effet éviter de changer trop souvent de phase de couplage. Après chaque changement de phase de couplage, une durée de quelques heures doit être respectée avant de relancer un scan des phases.

On note que, si le paramètre de qualité utilisé n'est pas le SNR mais le LQI, le seuil prédéfini est par exemple égal à 52.

Dans les modes de réalisation qui viennent d'être décrits, c'est donc le microcontrôleur 7 du compteur 1 qui évalue la qualité de la communication CPL et qui sélectionne la phase optimisée en fonction du résultat de cette évaluation.

Cependant, il est possible que la sélection de la phase optimisée soit réalisée à l'extérieur du compteur 1, par une entité externe.

Cette entité externe est par exemple un serveur du SI, ou bien un concentrateur de données, et est connectée à une pluralité de compteurs.

L'entité externe acquiert les valeurs du paramètre de qualité associées à tous ces compteurs, et détermine lui-même, pour chaque compteur 1, la phase optimisée à sélectionner.

Dans ce cas, le microcontrôleur 7 de chaque compteur 1 reçoit une commande de sélection transmise par le serveur du SI, extrait de la commande de sélection un identifiant de la phase optimisée qui a été sélectionnée par le serveur du SI, et pilote le circuit de commutation 10 pour connecter le module de communication 5 à ladite phase optimisée.

Cette solution présente l'avantage suivant par rapport à la précédente.

Si c'est le compteur 1 qui réalise lui-même la sélection, il est possible que, pendant les étapes de test et de connexion qui ont été décrites, un ou plusieurs autres compteurs démarrent eux-aussi des étapes de test et de connexion - ce qui peut avoir tendance à modifier le résultat de la sélection pour le compteur 1.

La grappe de compteurs peut alors mettre un temps assez important à se stabiliser.

Par contre, si la sélection est réalisée de manière globale et centralisée par une entité externe, cette entité externe peut séquencer les opérations de connexion, ce qui réduit le temps de stabilisation.

On notera cependant que, si la sélection est faite au niveau de chaque compteur, cette sélection est possiblement plus stable et peut permettre d'aboutir à une stabilisation permanente.

Bien entendu, l'invention n'est pas limitée aux modes de réalisation décrits mais englobe toute variante entrant dans le champ de l'invention telle que définie par les revendications.

Le paramètre de qualité utilisé n'est pas nécessairement le même systématiquement. Chaque compteur pourrait choisir dynamiquement le meilleur paramètre à utiliser (qui est par exemple celui qui donne des valeurs les plus éloignées du seuil prédéfini).

Le paramètre de qualité peut aussi être choisi dynamiquement par une entité centralisée sur la base d'observations réalisées sur une pluralité de compteurs.

Il est aussi possible d'utiliser plusieurs paramètres de qualité, soit pour confirmer le résultat de la sélection de la phase optimisée, soit pour produire un paramètre combiné à partir de plusieurs paramètres de qualité. Le paramètre combiné est par exemple obtenu par une moyenne pondérée des paramètres de qualité.

## Revendications

1. Compteur électrique (1), agencé pour mesurer une énergie électrique fournie à une installation par un réseau de distribution (2) comprenant une pluralité de phases (3), le compteur électrique comportant :
- un module de communication (5) agencé pour mettre en oeuvre une communication par courants porteurs en ligne ;
- un circuit de commutation (10) agencé pour sélectivement connecter le module de communication (5) à l'une des phases ;
- une unité de traitement (6) agencée pour piloter le circuit de commutation de manière à connecter le module de communication à une phase optimisée, parmi les phases (3), qui est sélectionnée dynamiquement pour optimiser une qualité de la communication par courants porteurs en ligne.

2. Compteur électrique selon la revendication 1, dans lequel l'unité de traitement (6) est agencée, pour chaque phase (3), pour évaluer la qualité de la communication par courants porteurs en ligne lorsque le module de communication (5) est connecté à ladite phase, et pour sélectionner la phase optimisée en fonction d'un résultat de cette évaluation.

3. Compteur électrique selon la revendication 2, la qualité de la communication par courants porteurs en ligne étant évaluée en fonction d'au moins un paramètre de qualité comprenant un niveau de signal sur bruit et/ou un taux de réussite d'échanges de trames.

4. Compteur électrique selon la revendication 3, dans lequel, lorsqu'une technologie CPL G3 est utilisée pour mettre en oeuvre la communication par courants porteurs en ligne, le niveau de signal sur bruit est codé entre 0 et 255, et dans lequel, lorsqu'une technologie CPL PRIME est utilisée pour mettre en oeuvre la communication par courants porteurs en ligne, le niveau de signal sur bruit est évalué en dB.

5. Compteur électrique selon l'une des revendications 3 ou 4, dans lequel l'unité de traitement (6) est agencée pour mettre en oeuvre les étapes de test et de connexion suivantes :
- piloter le circuit de commutation (10) de sorte que celui-ci connecte successivement le module de communication (5) à chaque phase (3) ;
- pour chaque phase (3), lorsque le module de communication (5) est connecté à ladite phase (3), évaluer ou acquérir le paramètre de qualité ;
- sélectionner comme phase optimisée la phase pour laquelle le paramètre de qualité est maximal, et piloter le circuit de commutation (10) de sorte que celui-ci connecte le module de communication (5) à ladite phase optimisée.

6. Compteur électrique selon la revendication 5, dans lequel l'unité de traitement (6) est agencée pour mettre en oeuvre les étapes de test et de connexion à intervalles réguliers.

7. Compteur électrique selon la revendication 5, dans lequel l'unité de traitement (6) est agencée pour :
- évaluer ou acquérir le paramètre de qualité lorsque le module de communication (5) est connecté à une phase courante ;
- lorsque le paramètre de qualité devient inférieur à un seuil prédéfini, mettre en oeuvre les étapes de test et de connexion.

8. Compteur électrique selon la revendication 1, dans lequel l'unité de traitement (6) est agencée pour recevoir une commande de sélection transmise par une entité externe, pour extraire de la commande de sélection un identifiant de la phase optimisée qui a été sélectionnée par l'entité externe, et pour piloter le circuit de commutation (10) de manière à connecter le module de communication (5) à ladite phase optimisée.

9. Compteur électrique selon l'une des revendications précédentes, dans lequel le circuit de commutation (10) comporte, pour chaque phase (3), un circuit unitaire (11) comprenant :
- une entrée (E) connectée au module de communication (5), et une sortie (S) connectée à ladite phase ;
- un circuit interrupteur (12) comprenant deux transistors (13a, 13b) et agencé pour, sélectivement, couper une liaison entre l'entrée (E) et la sortie (S), ou bien permettre ladite liaison en laissant passer des alternances positives et négatives de signaux CPL émis par ou à destination du module de communication (5) ;
- un circuit de commande (16) agencé pour recevoir un signal de commande primaire (Scp) produit par l'unité de traitement (6) et pour produire un signal de commande secondaire (Scs) pour piloter le circuit interrupteur (12).

10. Procédé de sélection, mis en oeuvre dans un compteur selon la revendication 5, et comprenant les étapes de test et de connexion suivantes :
- piloter le circuit de commutation (10) de sorte que celui-ci connecte successivement le module de communication (5) à chaque phase (3) ;
- pour chaque phase (3), lorsque le module de communication (5) est connecté à ladite phase (3), évaluer ou acquérir le paramètre de qualité ;
- sélectionner comme phase optimisée la phase pour laquelle le paramètre de qualité est maximal, et piloter le circuit de commutation (10) de sorte que celui-ci connecte le module de communication (5) à ladite phase optimisée.

11. Programme d'ordinateur comprenant des instructions qui conduisent l'unité de traitement (6) du compteur électrique (1) selon la revendication 5 à exécuter les étapes du procédé de sélection selon la revendication 10.

12. Support d'enregistrement lisible par ordinateur, sur lequel est enregistré le programme d'ordinateur selon la revendication 11.

## Patentansprüche

1. Stromzähler (1), der ausgebildet ist, eine von einem eine Vielzahl von Phasen (3) umfassenden Verteilungsnetz (2) an eine Anlage gelieferte elektrische Energie zu messen, wobei der Stromzähler umfasst:
- ein Kommunikationsmodul (5), das ausgebildet ist, eine Kommunikation mittels Powerline Communication durchzuführen;
- einen Schaltkreis (10), der ausgebildet ist, das Kommunikationsmodul (5) selektiv mit einer der Phasen zu verbinden;
- eine Verarbeitungseinheit (6), die ausgebildet ist, den Schaltkreis so zu steuern, dass das Kommunikationsmodul (5) mit einer optimierten Phase unter den Phasen (3) verbunden wird, die dynamisch ausgewählt wird, um eine Qualität der Kommunikation mittels Powerline Communication zu optimieren.

2. Stromzähler nach Anspruch 1, bei dem die Verarbeitungseinheit (6) ausgebildet ist, für jede Phase die Qualität der Kommunikation mittels Powerline Communication zu bewerten, wenn das Kommunikationsmodul (5) mit der genannten Phase verbunden ist, und die optimierte Phase in Abhängigkeit von einem Ergebnis dieser Bewertung auszuwählen.

3. Stromzähler nach Anspruch 2, wobei die Qualität der Kommunikation mittels Powerline Communication in Abhängigkeit von mindestens einem Qualitätsparameter bewertet wird, der einen Signal-Rausch-Pegel und/oder eine Erfolgsrate für den Frame-Austausch umfasst.

4. Stromzähler nach Anspruch 3, bei dem, wenn eine G3 PLC-Technologie verwendet wird, um die Kommunikation mittels Powerline Communication durchzuführen, der Signal-Rausch-Pegel zwischen 0 und 255 kodiert wird, und bei dem, wenn eine PRIME PLC-Technologie verwendet wird, um die Kommunikation mittels Powerline Communication durchzuführen, der Signal-Rausch-Pegel in dB bewertet wird.

5. Stromzähler nach einem der Ansprüche 3 oder 4, bei dem die Verarbeitungseinheit (6) ausgebildet ist, die folgenden Test- und Verbindungsschritte durchzuführen:
- Steuern des Schaltkreises (10), derart, dass dieser nacheinander das Kommunikationsmodul (5) mit jeder Phase (3) verbindet;
- wenn das Kommunikationsmodul (5) mit der genannten Phase (3) verbunden ist, Bewerten oder Erfassen des Qualitätsparameters für jede Phase (3);
- Auswählen derjenigen Phase als optimierte Phase, für die der Qualitätsparameter maximal ist, und Steuern des Schaltkreises (10) derart, dass dieser das Kommunikationsmodul (5) mit der genannten optimierten Phase verbindet.

6. Stromzähler nach Anspruch 5, bei dem die Verarbeitungseinheit (6) ausgebildet ist, die Test- und Verbindungsschritte in regelmäßigen Intervallen durchzuführen.

7. Stromzähler nach Anspruch 5, bei dem die Verarbeitungseinheit (6) ausgebildet ist, um:
- den Qualitätsparameter zu bewerten oder zu erfassen, wenn das Kommunikationsmodul (5) mit einer aktuellen Phase verbunden ist;
- wenn der Qualitätsparameter niedriger als ein vordefinierter Schwellenwert wird, Durchführen der Test- und Verbindungsschritte.

8. Stromzähler nach Anspruch 1, bei dem die Verarbeitungseinheit (6) ausgebildet ist, einen von einer externen Entität übertragenen Auswahlbefehl zu empfangen, um aus dem Auswahlbefehl eine Kennung der optimierten Phase, die von der externen Entität ausgewählt worden ist, zu extrahieren und den Schaltkreis (10) so zu steuern, dass das Kommunikationsmodul (5) mit der genannten optimierten Phase verbunden wird.

9. Stromzähler nach einem der vorhergehenden Ansprüche, bei dem der Schaltkreis (10) für jede Phase (3) einen unitären Kreis (11) umfasst, der enthält:
- einen Eingang (E), der mit dem Kommunikationsmodul (5) verbunden ist, und einen Ausgang (S), der mit der genannten Phase verbunden ist;
- eine Unterbrecherschaltung (12), die zwei Transistoren (13a, 13b) umfasst und ausgebildet ist, selektiv eine Verbindung zwischen dem Eingang (E) und dem Ausgang (S) zu trennen, oder auch die genannte Verbindung zu erlauben, indem positive und negative Wechsel von PLC-Signalen, die aus oder zu dem Kommunikationsmodul (5) gesendet werden, durchgelassen werden;
- eine Steuerschaltung (16), die ausgebildet ist, ein primäres Steuersignal (Scp) zu empfangen, das von der Verarbeitungseinheit (6) erzeugt wird, und ein sekundäres Steuersignal (Scs) zu erzeugen, um die Unterbrecherschaltung (12) zu steuern.

10. Auswahlverfahren, das in einem Zähler nach Anspruch 5 durchgeführt wird und die folgenden Test- und Verbindungsschritte umfasst:
- Steuern des Schaltkreises (10) derart, dass dieser das Kommunikationsmodul (5) nacheinander mit jeder Phase (3) verbindet;
- wenn das Kommunikationsmodul (5) mit der genannten Phase (3) verbunden ist, Bewerten oder Erfassen des Qualitätsparameters für jede Phase (3);
- Auswählen derjenigen Phase als optimierte Phase, für die der Qualitätsparameter maximal ist, und Steuern des Schaltkreises (10) derart, dass dieser das Kommunikationsmodul (5) mit der genannten optimierten Phase verbindet.

11. Computerprogramm, umfassend Anweisungen, die die Verarbeitungseinheit (6) des Stromzählers (1) nach Anspruch 5 dazu veranlassen, die Schritte des Auswahlverfahrens nach Anspruch 10 durchzuführen.

12. Computerlesbarer Aufzeichnungsträger, auf dem das Computerprogramm nach Anspruch 11 gespeichert ist.

## Claims

1. Electricity meter (1), arranged to measure electrical energy supplied to an installation by a distribution network (2) comprising a plurality of phases (3), the electricity meter comprising:
a communication module (5) arranged to implement a communication by power-line communication;
a switching circuit (10) arranged to selectively connect the communication module (5) to one of the phases;
a processor unit (6) arranged to control the switching circuit so as to connect the communication module to an optimised phase, from among the phases (3), which is selected dynamically to optimise a quality of the communication by power-line communication.

2. Electricity meter according to claim 1, wherein the processor unit (6) is arranged, for each phase (3), to evaluate the quality of the communication by power-line communication, when the communication module (5) is connected to said phase, and to select the optimised phase according to a result of this evaluation.

3. Electricity meter according to claim 2, the quality of the communication by power-line communication being evaluated according to at least one quality parameter comprising a signal to noise level and/or a frame exchange success rate.

4. Electricity meter according to claim 3, wherein, when a PLC G3 technology is used to implement the communication by power-line communication, the signal to noise level is coded between 0 and 255, and wherein, when a PLC PRIME technology is used to implement the communication by power-line communication, the signal to noise level is evaluated in dB.

5. Electricity meter according to one of claims 3 or 4, in which the processor unit (6) is arranged to implement the following test and connection steps:
controlling the switching circuit (10) such that it connects successively the communication module (5) to each phase (3);
for each phase (3), when the communication module (5) is connected to said phase (3), evaluating or acquiring the quality parameter;
selecting as the optimised phase, the phase for which the quality parameter is maximum, and controlling the switching circuit (10) such that it connects the communication module (5) to said optimised phase.

6. Electricity meter according to claim 5, wherein the processor unit (6) is arranged to implement the test and connection steps at regular intervals.

7. Electricity meter according to claim 5, wherein the processor unit (6) is arranged to:
evaluate or acquire the quality parameter when the communication module (5) is connected to a current phase;
when the quality parameter becomes less than a predefined threshold, implement the test and connection steps.

8. Electricity meter according to claim 1, wherein the processor unit (6) is arranged to receive a selection command transmitted by an external entity, to extract an identifier of the optimised phase from the selection command, which has been selected by the external entity, and to control the switching circuit (10) so as to connect the communication module (5) to said optimised phase.

9. Electricity meter according to one of the preceding claims, wherein the switching circuit (10) comprises, for each phase (3), a unitary circuit (11) comprising:
an input (E) connected to the communication module (5), and an output (S) connected to said phase;
a switch circuit (12) comprising two transistors (13a, 13b) and arranged to, selectively, cut off a connection between the input (E) and the output (S), or enable said connection by letting positive and negative alternances of PLC signals emitted from or to the communication module (5) pass through;
a command circuit (16) arranged to receive a primary command signal (Scp) produced by the processor unit (6) and to produce a secondary command signal (Scs) to control the switch circuit (12).

10. Selection method, implemented in a meter according to claim 5, and comprising the following test and connection steps:
controlling the switching circuit (10) such that it connects successively the communication module (5) to each phase (3);
for each phase (3), when the communication module (5) is connected to said phase (3), evaluating or acquiring the quality parameter;
selecting as the optimised phase, the phase for which the quality parameter is maximum, and controlling the switching circuit (10) such that it connects the communication module (5) to said optimised phase.

11. Computer program comprising instructions which cause the processor unit (6) of the electricity meter (1) according to claim 5, to execute the steps of the selection method according to claim 10.

12. Computer-readable storage medium, on which the computer program according to claim 11 is stored.
